# EUROPEAN PATENT SPECIFICATION

(11) **EP 4 623 647 B1**
(45) Date of publication and mention of the grant of the patent: **13.05.2026**
(21) Application number: 24710448.2
(22) Date of filing: 14.03.2024
(51) Int. Cl.: H05K 1/02, H01L 23/36, H01L 23/373, H05K 1/18, H05K 3/34, H05K 1/03

(54) **A THERMAL CONDUCTOR COMPONENT**
WÄRMELEITERKOMPONENTE
COMPOSANT CONDUCTEUR THERMIQUE

(30) Priority: 14.03.2023 EP 23161885
(43) Date of publication of application: 01.10.2025
(73) Proprietor: Lotus Microsystems ApS, 2650 Hvidovre (DK)
(72) Inventor: NOUR, Yasser A. A., 2650 Hvidovre (DK); THANH, Hoà Lê, 2650 Hvidovre (DK); AMMAR, Ahmed Morsi, 2650 Hvidovre (DK)
(74) Representative: Høiberg P/S
(86) International application number: PCT/EP2024/056784
(87) International publication number: WO 2024/189135

(56) References cited:
- WO-A1-2019/060402
- US-A1- 2022 029 262
- US-A1- 2022 359 389

## Description

The present disclosure relates to a thermal conductor component (Q-guide) configured for efficiently conducting heat between a first and a second area in an electronic system.

### Background

In smart electronic systems, for example, internet of things (IoT) devices, light-emitting diode (LED) lightings, and other consumer electronic products, a general trend is that an increasing number of functions is packed into a limited space. These systems consequently require squeezing the different integrated circuits together, and preferably as close as possible.

One challenge with developing smaller electronic systems where integrated circuits are arranged very close to each other and sometimes stacked on top of each other is the thermal performance. In battery-operated devices, for example, good thermal performance is key to a safe operation and a long battery life, especially for portable devices. Significant amounts of heat can also affect the reliability of an electronic device, or even cause it to fail. The build-up of heat can ultimately affect the functional life of the electronic device.

The prior art often employs fans, heat sinks, liquid cooling devices or, in a smaller scale, Q-guide thermal conductors, mainly constructed with aluminium nitride or beryllium oxide, as means of reducing heat build-up in electronic devices.

One issue with the Q-guide thermal conductors is that they generally are manufactured using one-piece construction, providing a RoHS-compliant SMT package. In some specific applications where space optimization is key, they might not fulfil the needs of the electronic system.

US 2022/359389 A1 discloses a surface-mountable thin-film fuse component that may include a substrate having a top surface, a first end, and a second end that is spaced apart from the first end in a longitudinal direction. The thin-film component may include a fuse layer formed over the top surface of the substrate. The fuse layer may include a thin-film fuse track. An external terminal may be disposed along the first end of the substrate and electrically connected with the thin-film fuse track. The external terminal may include a compliant layer comprising a conductive polymeric composition.

WO 2019/060402 A1 discloses a thermal connector comprising an electrically insulating beam having a first end face at a first end and a second end face at a second end. The second end face may be opposite the first end face in an X direction. The beam may have a width in a Y direction perpendicular to the X direction. The beam may also have a top face and a bottom face offset from the top face in a Z direction. The thermal connector may include a first terminal attached to the bottom face and adjacent the first end and a second terminal attached to the top face and adjacent the first end. The connector may have an overall thickness in the Z direction, which includes the first and second terminals and is greater than 1.27 mm and less than 3.81 mm.

US 2022/029262 A1 discloses a coupler having improved power handling for RF and thermal bridge applications.

### Summary

Thus, there exists a need for building a thermal guide device with a high thermal conductivity and a scalable size which would fit any applications, with cheaper materials. As disclosed herein, this can be achieved by a thermal guide electrical component according to claim 1.

One advantage of providing a thermal guide electrical component on a silicon substrate is that the manufacturing can be achieved in a cheaper way. The size of the thermal guide electrical component can also be adjusted in order to fit any application. The manufacturing process is similar to the manufacturing process of integrated circuits manufactured on a silicon substrate, which makes the thermal guide electrical component being potentially manufactured following the same methods. This may decrease the price compared to current thermal guide electrical component, which are mainly manufactured with an aluminium oxide-based or beryllium oxide structure. The manufacturing of an aluminium oxide-based or beryllium oxide structure is also costly compared to manufacturing of electrical components based on a silicon substrate. The third portion may, preferably, be an electrically isolative portion configured such that the at least two first portions are electrically isolated from the fourth silicon substrate portion. The third portion may advantageously comprise a material that would increase the thermal conductivity of the thermal guide electrical component.

The portions, such as the at least two first portions and/or the third portion as described herein, can be arranged or deposited on other portions, such as the at least two first portions, the third portion and/or the fourth silicon substrate portion. A portion being arranged may have an equivalent meaning as a portion being deposited, in the field of microelectronics, such as for the thermal guide electrical component as disclosed herein. The term "arranged" may refer to a spatial arrangement or positioning of the portions between each other. The term "deposited" may refer to one or more depositions of one or more portions, by means of deposition. A deposition can involve a spatial arrangement or positioning of the portions between each other, in the way these portions are deposited.

The disclosure further relates to a method of conducting heat between a first and a second area according to claim 14.

The method allows for more efficient heat conduction between the first and the second area, by providing a thermal guide component comprising at least two first portions, wherein the first portions are electrically conductive connector portions connectable to the first and the second area. The thermal guide component is comprising a fourth silicon substrate portion arranged on the third portion, which makes the thermal guide cheaper to produce than any conventional thermal bridges or Q-bridges with an equivalent structure and/or size.

### Description of the drawings

In the following embodiment and examples will be described in greater detail with reference to the accompanying drawings. The drawings are non-limiting examples of embodiments and are intended to illustrate some of the features of the presently disclosed thermal guide electrical component.
Fig. 1A-F illustrates schematic views of a section of an embodiment of the thermal guide electrical component as disclosed herein,
Fig. 2 shows a schematic view of a section of an embodiment of the thermal guide electrical component as disclosed herein where the first portions have trenches comprised in the second portion,
Fig. 3 shows a 2D side view of one embodiment of the thermal guide electrical component as disclosed herein,
Fig. 4 shows a simulation setup demonstrating the efficiency of the thermal guide electrical component disclosed herein compared to a Q-bridge thermal conductor of a similar size, and constructed with Aluminium Nitride (AIN).
Fig. 5 shows an example of a flow chart of the presently disclosed method of conducting heat between a first area and a second area.

### Detailed description

The present disclosure relates to a thermal guide electrical component configured for conducting heat between a first and a second area comprising at least two first portions, wherein the first portions are electrically conductive connector portions connectable to the first and the second area; a third portion, wherein the third portion is at least one layer of an electrically isolative portion arranged on the at least two first portions; and a fourth silicon substrate portion, wherein the fourth silicon substrate portion is arranged on the third portion such that the third portion forms an electrical barrier between the at least two first portions and the fourth silicon substrate portion, wherein the thermal guide electrical component is configured to transfer a heat portion from the first area to the second area.

Transferring heat from the first area to the second area may refer to the movement of thermal energy from a region of higher temperature to a region of lower temperature. Heat transfer can occur through three main mechanisms: conduction, convection, and radiation.

Conduction may be a heat transfer that occurs when there is a temperature gradient within a solid, causing heat to flow from the hotter region to the colder region. This may occur through the transfer of energy between adjacent molecules in the material, without any net movement of the material as a whole.

Conduction or heat transfer in a solid or preferably in a thermal guide electrical component as described herein can be measured using the following methods:
- Thermal Conductivity Measurement: This method consists in measuring the thermal conductivity of the material. Thermal conductivity is a material property that describes the rate at which heat flows through a material, given a temperature gradient. The measurement of thermal conductivity can be done using a variety of techniques, such as the steady-state method, transient method, and guarded hot plate method.
- Thermal Resistance Measurement: This second potential method consists in measuring the thermal resistance of the material. Thermal resistance is the inverse of thermal conductivity and describes the resistance of a material to heat flow. The measurement of thermal resistance can be done using a variety of techniques, such as the guarded hot plate method, transient plane source method, and the two-layer method.
- Infrared thermography is a non-contact method that can be used to visualize and measure temperature distribution and heat flow within a material or between two materials in contact. Infrared cameras can detect and measure infrared radiation emitted by the surface of the material, which is related to the surface temperature and hence the heat flow.

Other methods may exist and could be used to measure the heat transfer in the thermal guide electrical component.

There are also several simulation methods that can be used to simulate heat transfer or conduction. Some of the commonly used methods are:
- Finite Element Method (FEM) is a numerical method that is used to solve complex heat transfer problems. In this method, the problem domain is divided into small finite elements, and the temperature distribution within each element is approximated using a set of linear equations. The equations are then solved using iterative methods, and the temperature distribution is obtained.
- Finite Volume Method (FVM) is a method that is used to discretize the heat transfer equation into a set of algebraic equations. In this method, the problem domain is divided into small control volumes, and the heat transfer equation is integrated over each volume. The solution is then obtained by solving the set of algebraic equations.
- Boundary Element Method (BEM) is a method that is used to solve problems involving heat transfer across boundaries. In this method, the boundary of the problem domain is divided into small elements, and the temperature distribution within each element is approximated. The equations are then solved using iterative methods, and the temperature distribution is obtained.
- Monte Carlo Method is a stochastic method that is used to solve problems involving random variables. In this method, a large number of random samples are generated, and the temperature distribution is obtained by averaging the results over all the samples.

Each of these methods may have its own advantages and disadvantages, and the choice of method can depend on the specific problem being solved and the available computational resources.

The heat portion may be a principal heat portion. The heat portion can be transferred with different level of intensity in the different portions of the thermal guide electrical component. Preferably, the heat portion may be preferably transferred in the at least two first portions, the second portion, the third portion, the fifth portion and/or the fourth silicon substrate portion. The heat portion can be the transferred heat from the first area to the second area, or from the second area to the first area.

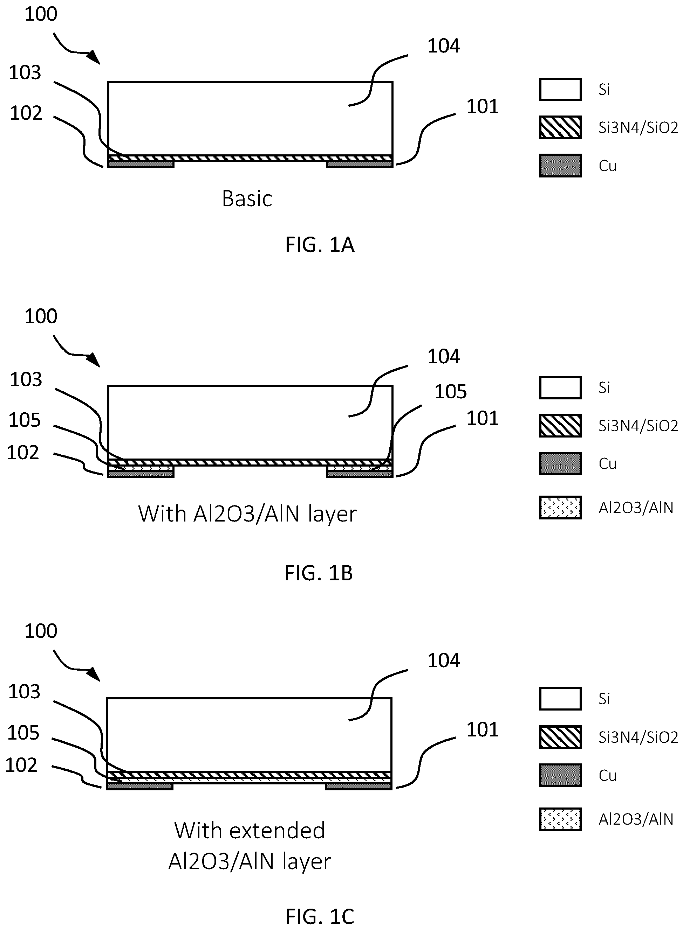

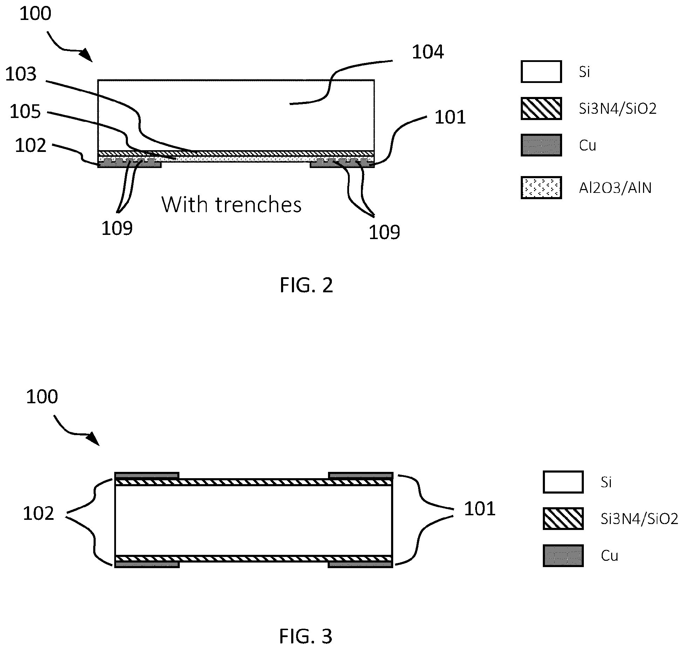

Fig. 1A shows a schematic view of a section of an embodiment of the thermal guide electrical component (100) as disclosed herein. In all of Figs. 1A-1F, as well as in Fig. 2, specific materials are given in the form of examples. A person skilled in art will realize that the thermal guide electrical component is not necessarily limited to the materials in the examples but can be any material that is suitable for any specific portion. The at least two first portions (101,102) are made of copper (Cu), which may be an efficient electrically conductive material. The at least two first portions (101,102) may be advantageously solderable, so that they can be soldered to a first and a second area, respectively. The third portion is arranged between the at least two first portions and the fourth silicon substrate portion (104). The third portion (103) is made of silicon nitride (Si₃N₄) and/or silicon dioxide (SiO₂), which makes the third portion being an electrically isolative portion, in order to electrically isolate the at least two first portions and the fourth silicon substrate portion (104).

The first area and the second area may be areas comprised in the same integrated circuit, but it can also be areas located on different integrated circuits and/or printed circuit boards. Preferably, the first and the second area may be comprised in the same integrated circuit and on the same surface, so that the thermal guide component as described herein can be soldered on both surfaces with the at least two first portions.

The thermal guide electrical component may further comprise a second portion. The second portion can be a thermally conductive and substantially non-electrically conductive portion, and may be arranged between the first and the third portion. The second portion may preferably help dissipating the heat from the first portion to the third portion. Preferably, the second portion may be highly thermally conductive in order to conduct as much heat as possible from the first portion and/or the third portion towards the first portion or the third portion.

The second portion can be configured to assist the fourth silicon substrate portion in transferring the principal heat from the first portion to the third portion. Advantageously, the second portion can be a non-electrically conductive portion, so that it can electrically isolate the first portion from the third portion and vice-versa, and it may efficiently dissipate or propagate the heat from the first portion and the third portion. The principal heat may be heat generated from a component or an area generating heat such as power transistors, voltage regulators, microprocessors, switching power supplies. Power transistors are used to switch high voltages and currents in power electronics applications. They can produce a lot of heat due to the high power levels involved. Voltage regulators are used to regulate the voltage in electronic circuits. They can produce heat due to the voltage drop across the regulator and the current flowing through it. Switching power supplies are used to convert AC voltage to DC voltage in electronic devices. They can produce heat due to the switching of high currents at high frequencies.

Fig. 1B shows a schematic view of a section of an embodiment of an embodiment of the thermal guide electrical component (100) as disclosed herein. In this embodiment the at least two first portions (101,102) are made of copper (Cu), which may be an efficient electrically conductive material. The at least two first portions (101,102) may be advantageously solderable, so that they can be soldered to a first and a second area, respectively. The second portion (105) is arranged between the at least two first portions (101,102) and the third portion (103). The second portion (105) is made of aluminium oxide (Al₂O₃) and/or aluminium nitride (AIN). These materials may have the advantage to be electrical insulators as well as good thermally conducting materials, therefore improving the thermal conductivity between the at least two first layers and the third layer. As shown in Fig. 1B, the second portion (105) is arranged only above the surface defined by the at least two first portions (101,102). This minimizes the surface of the second portion and therefore minimize the cost of the thermal guide electrical component, while still substantially improving the thermal conductivity from the at least two first portions to the third portion. The third portion (103) is arranged between the second portion and the fourth silicon substrate portion (104). The third portion (103) is made of silicon nitride (Si₃N₄) and/or silicon dioxide (SiO₂), which makes the third portion (103) being an electrically isolative portion, in order to electrically isolate the at least two first portions and the fourth silicon substrate portion (104).

Fig. 1C shows a schematic view of a section of an embodiment of the thermal guide electrical component (100) as disclosed herein. The at least two first portions (101,102) are made of copper (Cu), which may be an efficient electrically conductive material. The at least two first portions (101,102) may be advantageously solderable, so that they can be soldered to a first and a second area, respectively. The second portion (105) is arranged between the at least two first portions (101,102) and the third portion (103). The second portion (105) is made of aluminium oxide (Al₂O₃) and/or aluminium nitride (AIN). These materials may have the advantage to be electrical insulator as well as good thermal management material, therefore improving the thermal conductivity between the at least two first layers and the third layer. As shown in Fig. 1C, the second portion (105) is arranged below the third portion (103) and covers the entirety of the third portion, while not being only limited to the surface above the at least two first portions. This may substantially improve the thermal conductivity from one of the two first portions to the other one, since the heat can be efficiently conducted with a higher thermal conductivity between the two portions thanks to the second portion properties. The third portion (103) is arranged between the second portion (105) and the fourth silicon substrate portion (104). The third portion (103) is made of silicon nitride (Si₃N₄) and/or silicon dioxide (SiO₂), which makes the third portion being an electrically isolative portion, in order to electrically isolate the at least two first portions and the fourth silicon substrate portion (104).

The electrically conductive connector portions may be made of an electrically conductive material. Preferably, the electrically conductive material can be highly conductive such as copper, which, by reference may have a conductivity around 385 W/(m·K), but this can also be gold or silver, which, by reference, may have a conductivity of around 314 W/(m·K) and 406 W/(m·K), respectively. The conductivity for any material is temperature dependent. Copper may be preferred for its cost that can be cheaper than gold or silver. The electrically conductive connector portions may be designed such as components may be soldered on it. A port of an electronic component can be soldered on the electrically conductive portions such as a port of a passive component or a port of a power transistor, or any other ports of an electronic or microelectronic integrated circuit or component. Preferably, the electrically conductive portions may be pads, which is a small area on a semiconductor device that can be designed to facilitate electrical connections. Pads are preferably made of a conductive material, such as copper, and are used as contact points for wire bonding or soldering connections. Advantageously, this would enable the thermal guide electrical component to be connected to any auxiliary pads that needs to dissipate heat while being potentially electrically isolated.

The electrically conductive material can be made with a solderable material, preferably a metal, such as copper (Cu). As described herein, the electrically conductive material can be any material that can preferably be solderable, and can conduct electrical charges.

The at least two first portions may comprise at least one trench. The at least one trench is substantially penetrating the second portion. As shown in Fig. 2, which shows an embodiment of the thermal guide electrical component (100), the at least two first portions (101, 102) may have trenches (109) extending into the second portion (105). The first portions (101, 102) may be made of copper, and may substantially penetrate the second portion (105), which allows more surface of the copper being in contact with the material constituting the second portion (105), which may be Al₂O₃/AlN. By having more copper area in contact with the second portion (105), better thermal conduction can be achieved.

The at least one trench can be manufactured with/following an etching process. Etching is a process in which material is selectively removed from a surface using a chemical or physical process. The purpose of etching is to create a pattern on the surface or to modify its properties. Etching can be done using a variety of methods, including wet etching and dry etching. Wet etching involves immersing the substrate in a liquid solution that reacts with the material to be removed, while dry etching uses plasma or other physical means to remove the material. The choice of etching method can depend on the material being etched and the desired pattern or structure. Other manufacturing methods such as deposition, lithography, laser ablation or electroplating can be used to process the at least one trench.

The at least one trench can be at least one partial trench. The at least one partial trench or the at least one trench can be etched within the second portion.

In one embodiment, the first portion is deposited on the second portion, and wherein the first portion is filing the at least one partial trench. The at least one partial trench can be the at least one trench.

In a preferred embodiment, the at least one partial trench has a partial trench height. The at least one trench can have a trench height. The trench height can be the height of the trench. The height of the trench can refer to a depth of the trench etched into one of the portions as described herein, such as the second portion, the at least two first portions, the third portion or the fourth silicon substrate portion. The trench height or the height of the trench can be defined as the vertical distance from the top surface of the material or the portion where the trench is performed to the bottom of the trench.

The at least one trench may be penetrating the second portion down to 10%, preferably 20%, more preferably 50%, even more preferably 75%, most preferably 90% of a second portion height or a second portion thickness. Preferably, the more the at least one trench penetrates the second portion down, the better the thermal conduction from the at least two first portions to the other portions. On the other hand, the more the at least one trench penetrates the second portion down, the lower the allowed voltage breakdown of the thermal guide electrical component. Advantageously, a compromise may be found in order to satisfy the required thermal conductivity while allowing sufficient breakdown voltage.

In order to potentially increase the voltage breakdown, the second portion can be substantially thicker below the at least two first portions. This may be efficient if a high voltage breakdown is needed for the at least two first portions while allowing substantially deep trenches of the first portions within the second portion. A thicker second portion allows a better protection against voltage breakdown since it may increase the distance between the first portions to the neighbouring portions such as the second, the third, the fifth and/or the fourth silicon substrate portion.

The at least one trench may also reduce the capacitance loading on the first portions. By having the at least one trench, a better thermal diffusion/conductivity may be achieved while maximizing the distance between the shallow of the trenches to the third, fifth and/or fourth silicon substrate layer. This may be advantageous when the capacitive loading on the first portions should be minimized if the thermal guide electrical component is connected to a first and a second area, where the first and/or the second area are sensitive to capacitive loading. Especially if the first area and/or the second area are areas where RF/microwave frequencies are of interest. Advantageously, a low capacitance is required on these areas or nodes, so that they can be substantially transparent at the frequencies of interest.

The electrically conductive connector portions can have a connector surface between 0.027 and 25 mm², more preferably 0.027 and 5.6 mm², even more preferably 0.027 and 0.79 mm². The electrically conductive connector portions can be adapted to any types of applications, where large area may need to be connected to the electrically conductive connector portions. A larger area may benefit from a solid bonding, which can also potentially help conducting the heat from the first area to the electrically conductive connector portion being soldered to it. Preferably, the connector surface can be adapted to be compliant with standards, such as surface mount device (SMD) components, that comes in a range of sizes and shapes, commonly designated by standard codes. Some examples are described below:
- 0201: This is the smallest SMD package size, measuring 0.6 mm x 0.3 mm. It may be used for small resistors and capacitors.
- 0402: This package size measures 1.0 mm x 0.5 mm and may be used for resistors, capacitors, and diodes.
- 0603: This package size measures 1.6 mm x 0.8 mm and may be used for resistors, capacitors, and inductors.
- 0805: This package size measures 2.0 mm x 1.25 mm and may be used for resistors, capacitors, and inductors.
- 1206: This package size measures 3.2 mm x 1.6 mm and may be used for resistors, capacitors, and inductors.
- 1210: This package size measures 3.2 mm x 2.5 mm and may be used for resistors, capacitors, and inductors.
- 1812: This package size measures 4.5 mm x 3.2 mm and may be used for resistors, capacitors, and inductors.
- 2220: This package size measures 5.6 mm x 4.5 mm and may be used for high power resistors, capacitors, and inductors.
- 3528: This package size measures 3.5 mm x 2.8 mm and may be used for LED packages.

The electrically connector portions can also have an even larger connector surface, such as 100 mm², preferably in the case where one of the electrically connector portions may be connected to a heat dissipation system, such as a fan or a heat sink, or bonded to a large ground plane.

The electrically conductive connector portions may have a height or a thickness between 10 and 50 µm. The height or the thickness may need to be chosen depending on the connection that may need to be arranged on the electrically conductive connector portions. Advantageously, a low height or thickness would save material, but would make the electrically conductive connector portions more fragile in case of soldering. A large height or thickness would make the connector stronger but would increase the amount of material.

The thermally conductive and substantially non-electrically conductive portion may be made with a material comprising aluminium. Materials comprising aluminium may be good candidates for conducting heat, since the thermal conductivity value of the aluminium is high, around 237 W/m.K. The material comprising aluminium can be aluminium oxide (Al₂O₃) and/or aluminium nitride (AIN). These materials may have the advantage to be electrical insulator as well as good thermal management material. Al₂O₃ can be used as an electrical insulator, and may have good thermal properties. This can advantageously use as a thermal barrier or as a thermal interface material. Al₂O₃ can be also used as a gate oxide in metal-oxide-semiconductor field-effect transistor (MOSFET) devices to electrically insulate the gate electrode from the channel region. Al₂O₃ may be a popular choice for gate oxide material because it may have a relatively high dielectric constant compared to other insulators. AIN may also be an electrical insulator, with a high dielectric strength. One of the key properties of AIN may be its high thermal conductivity, which may make it an excellent thermal management material in microelectronics. AIN may have a thermal conductivity that is around three times higher than that of Al₂O₃. A mix between Al₂O₃ and AIN may provide a robust combination in order to provide an efficient thermally conductive and substantially non-electrically conductive portion. The thermal conductivity of Al₂O₃ is around 25-40 W/m.K while the thermal conductivity of AIN is around 140-320 W/m.K.

These thermal conductivity values can vary depending on various factors such as impurities and material structure.

The electrically isolative material can be made with a material comprising silicon. The material comprising silicon may be silicon nitride (Si₃N₄) and/or silicon dioxide (SiO₂). Si₃N₄ can have a high dielectric strength, which means it can withstand high electric fields without breaking down. This may make it useful for applications where electrical isolation is required, such as in the passivation layer of a microelectronic device or in the gate dielectric of a MOSFET. In the present disclosure, it may be required in order to isolate the at least two first portions made of an electrically conductive material to the fourth silicon substrate portion. Si₃N₄ may also have good thermal properties and can be used as a thermal barrier or as a thermal interface material.

SiO₂ may also be an excellent electrical insulator with a high dielectric strength. It can be used as a gate oxide in MOSFETs, where it can help to improve device performance by reducing the gate leakage current. SiO₂ can also be a popular choice for the passivation layer in microelectronic devices, where it helps to protect the underlying components from environmental factors.

Both Si₃N₄ and SiO₂ have good chemical and mechanical properties, which make them attractive for use in microelectronics. In the present disclosure, it may be preferably use for their isolative properties, even though their good thermal properties may help conducting the principal heat from the first area to the second area.

In one embodiment, the thermal guide electrical component further comprises a fifth portion. The fifth portion can be arranged between the third portion and the fourth substrate portion. The fifth portion is a diffusion barrier layer. Diffusion barrier layer can comprise material such as titanium nitride (TiN), tantalum nitride (TaN), tungsten (W), molybdenum (Mo), ruthenium (Ru), platinum (Pt), cobalt (Co), nickel (Ni). A diffusion barrier layer may prevent unwanted diffusion or migration of atoms or ions between layers, preferably between the third portion and the fourth silicon substrate portion. By using a diffusion barrier layer, issues such as short circuits, increased resistivity or reliability issues can be prevented or minimized. This would improve device performance and reliability.

Preferably, the diffusion barrier layer may be made with TiN and/or TaN. TiN and/or TaN may be preferred as material used for the fifth portion because of several arguments:
- TiN and TaN can have excellent adhesion to a variety of materials commonly used in microelectronics, which may allow for good coverage and uniformity of the barrier layer.
- Both TiN and TaN may have high melting points, which can make them suitable for use in high-temperature processes, such as those used in the fabrication of copper interconnects.
- TiN and TaN have been shown to have good barrier properties, which means they may be effective at preventing the diffusion of copper or other metal atoms into adjacent layers.
- Both TiN and TaN are chemically stable, which means they may be less likely to react with other materials or impurities in the device and cause reliability issues.
- TiN and TaN may have relatively low resistivity, which means they can be used as a conducting layer in addition to serving as a diffusion barrier.

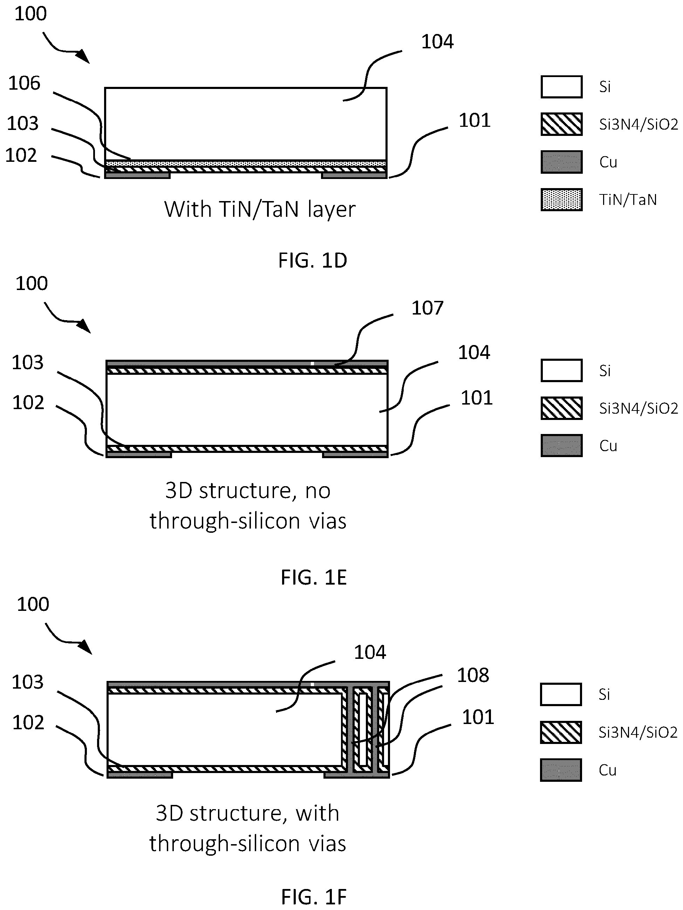

Fig. 1D shows a schematic view of a section of an embodiment of the thermal guide electrical component (100) as disclosed herein. The at least two first portions (101,102) are made of copper (Cu), which may be an efficient electrically conductive material. The at least two first portions (101,102) may be advantageously solderable, so that they can be soldered to a first and a second area, respectively. The third portion is arranged between the at least two first portions and the fifth portion (106). The fifth portion is arranged between the third portion (103) and the fourth silicon substrate portion (104). The fifth portion (106) is made with TiN and/or TaN. It constitutes a diffusion barrier layer and may prevent or minimize issues such as short circuits, increased resistivity or reliability issues. The third portion (103) is made of silicon nitride (Si₃N₄) and/or silicon dioxide (SiO₂), which makes the third portion being an electrically isolative portion, in order to electrically isolate the at least two first portions and the fourth silicon substrate portion (104).

The thermal guide electrical component may have an upper surface and/or a lower surface between 0.08 and 38 mm², preferably 0.08 and 28.8 mm², more preferably 0.18 and 28.8 mm², even more preferably 0.18 and 8 mm², most preferably 0.18 and 2.6 mm². The upper surface and/or the lower surface may be compliant with SMD package size standards as described herein. The upper surface and/or the lower surface may also be designed and have a size that would pass specific applications, where SMD standards would not be compliant. The thermal guide electrical component as disclosed herein, may have the flexibility of being designed such as various sizes can be obtained, without substantially increasing the complexity of the fabrication.

The fourth silicon substrate portion can have a fourth silicon substrate portion height or a fourth silicon substrate portion thickness between 100 and 525 µm. The possible heights or thicknesses of the fourth silicon substrate depends on the application. For instance, 100 µm is a common thickness for silicon substrates used in microelectromechanical systems (MEMS) applications. Thinner substrates may also be more fragile and can be more difficult to handle and process. 300 µm can be a preferred thickness for silicon substrates used in discrete components such as diodes and transistors. Thicker substrates may be advantageous for discrete components because they can provide greater mechanical stability and support, which can help prevent cracking and deformation during processing and use. However, thicker substrates can also require more energy to process and may be more expensive.

The second portion may have a second portion height or a second portion thickness between 20 and 400 nm. A thick layer, preferably higher than 300 nm, may improve mechanical strength and stability of the underlying layers, may provide better diffusion barrier performance, can help improve the performance and reliability of the device by providing a better insulation and passivation of the underlying layers, and can advantageously provide enhanced thermal conductivity. The preferred thickness of the second portion can depend on the specific requirements of the thermal guide electrical component for a specific application and can be chosen accordingly.

The trench height or partial trench height can be substantially lower than the second portion thickness or the second portion height. The at least one trench can be etched within the second portion, but preferably not within the third portion or the fourth substrate portion. Thereby, the trench height can be substantially lower than the second portion thickness, since a trench height which would have a higher trench height than the second portion thickness would be etched within the third portion or the fourth silicon substrate portion.

The third portion can have a third portion height or a third portion thickness between 0.1 and 5 µm. A thick layer, preferably higher than 1 µm, may improve mechanical strength and stability of the underlying layers, may provide better diffusion barrier performance, can help improve the performance and reliability of the device by providing a better insulation and passivation of the underlying layers, and can advantageously provide enhanced thermal conductivity. The preferred thickness of the third portion can depend on the specific requirements of the thermal guide electrical component for a specific application and can be chosen accordingly.

The fifth portion may have a fifth portion height or a fifth portion thickness between 20 and 200 nm. A thick layer of the fifth portion may provide better barrier properties, improved adhesion and reduced resistance of the interconnections. A thinner layer would decrease the processing time by requiring a shorter deposition time, would decrease the additional stress in the material itself and may potentially increase the capacitance of the interconnections. Keeping the capacitance low would be beneficial if the thermal guide electrical component may need to dissipate heat from a first area to a second area, and where the first area and/or the second area are areas where RF/microwave frequencies are of interest. Advantageously, a low capacitance is required on these areas or nodes, so that they can be substantially transparent at the frequencies of interest. The preferred thickness of the fifth portion can depend on the specific requirements of the thermal guide electrical component for a specific application and can be chosen accordingly.

In a preferred embodiment, each of the at least two first portions are located on opposite sides of the fourth silicon substrate portion. Preferably, each of the at least two first portions are located on the opposite vertical sides of the fourth silicon substrate portion, where the fourth silicon substrate portion is wider than higher. Fig. 1E shows a schematic view of a section of an embodiment of the thermal guide electrical component (100) as disclosed herein. The at least two first portions (101,102,107) are made of copper (Cu), which may be an efficient electrically conductive material. The at least two first portions (101,102,107) may be advantageously solderable, so that they can be soldered to a first and a second area, respectively. The at least two first portions comprise in this specific embodiment an additional portion (107) on top of the fourth silicon substrate (104), such that heat can be dissipated on top of the thermal guide electrical component (100). This additional portion (107) can also be soldered or coupled to a heat dissipation system in order to maximize the heat dissipation of this additional portion (107) The third portion (103) is arranged between the at least two first portions and the fifth portion (106). The fifth portion is arranged between the third portion (103) and the fourth silicon substrate portion (104). The fifth portion (106) is made with TiN and/or TaN. It constitutes a diffusion barrier layer and may prevent or minimize issues such as short circuits, increased resistivity or reliability issues. The third portion (103) is made of silicon nitride (Si₃N₄) and/or silicon dioxide (SiO₂), which makes the third portion being an electrically isolative portion, in order to electrically isolate the at least two first portions and the fourth silicon substrate portion (104).

The second, the third and/or the fifth portions may also be located on opposite sides of the fourth silicon substrate portion. As shown in Fig. 1E, the third portion (103) is located on opposite sides of the fourth silicon substrate portion (104), and may be used to electrically isolate the at least two first portions (101,102,107) to the fourth silicon portion (104) on the opposite sides of the thermal guide electrical component (100).

The at least two connector portions may be interconnected through the fourth silicon substrate portion. The interconnection between the at least two connector portions may be realised with through-silicon vias, but can also be realised with any other methods that would enable a 3D integration in a semiconductor device. In a preferred embodiment, an interconnection between the at least two connectors is performed via through-silicon vias through the fourth silicon substrate portion.

Fig. 1F shows a schematic view of a section of an embodiment of the thermal guide electrical component (100) as disclosed herein. The at least two first portions (101,102) are made of copper (Cu), which may be an efficient electrically conductive material. The at least two first portions (101,102) may be advantageously solderable, so that they can be soldered to a first and a second area, respectively. One of the two portions (101) is interconnected with the top of the fourth silicon substrate through through-silicon vias (108). The through-silicon vias comprise the material of the first portions as well as the third portion, which isolate the electrically conductive material of the first portions to the fourth silicon substrate portion. In this specific embodiment, the portion on the right enables a larger dissipation area of the heat through the upper side of the thermal guide electrical component. This upper side can also be soldered or coupled to a heat dissipation system in order to maximize the heat dissipation of this additional area of the one of the two portions (101), where this additional area is connected together with the one of the two portions (101) through the through-silicon vias (108). These through-silicon vias (108) can also enable an electrical connection from the bottom side of the thermal guide electrical component to the top side of the thermal guide electrical component, while providing an improved thermal dissipation.

In one embodiment, the through-silicon vias comprise the second, the third and/or the fifth portions. By having the through-silicon vias comprising the second, the third and/or the fifth portions, a better thermal dissipation as well as a better diffusion barrier layer can be achieved throughout the through-silicon vias.

The second, the third and/or the fifth portions may comprise at least one section. As shown in Fig. 1B, the second layer comprises two sections. The same principle can apply to the third and/or the fifth portions, where for instance in Fig. 1D, the third (103) and the fifth portion (106) could be implemented only above the at least two first portions (101,102). This would minimize the amount of material in the third and the fifth layer, therefore minimizing the cost of the fabrication of the thermal guide electrical component.

Each of the at least two connectors can have an electric potential difference between 5 and 2000 V, but may also be at least 400 V and/or between 5 and 48 V and/or between 650 and 1200 V. Typically, in some bus applications, as well as in automotive applications and in some industrial systems, the electric potential difference is greater than 400 V. Preferably, the at least two connectors can withstand an electrical potential difference which can be substantially high. This may be useful for applications where one of the at least two connectors have a very high electric potential and where the heat generated around this connector needs to be dissipated through the thermal guide electrical component in the second area, and where the second area can be a ground plane, where the ground plane may typically be connected to the ground. Ground may be the common reference point in an electrical circuit, and may serve as the zero-voltage reference point.

Fig. 3 shows a 2D side view of an embodiment of the thermal guide electrical component (100) where the at least two first portions (101,102) are located on each side of the thermal guide component area. Each of the at least two first portions are located on both the upper and the lower side of the thermal guide electrical component. This may allow the thermal guide electrical component to conduct heat between a first area being connected to one of the at least two first portions such as the left one (102), and a second area being connected to another of the at least two first portions such as the right one (101). By having the at least two first portions on both sides and on the upper and lower side of the thermal guide electrical component, the first area and the second area can be located on either same vertical side or on opposite sides of the thermal guide electrical component. This specific structure made by the at least two first portions as shown in Fig. 3 is commonly known as a "no-wrap" surface-mounted device (SMD) component. This "no-wrap" standard may be directly mounted onto the first and/or the second area, where the first and/or the second area can be a printed circuit board (PCB).

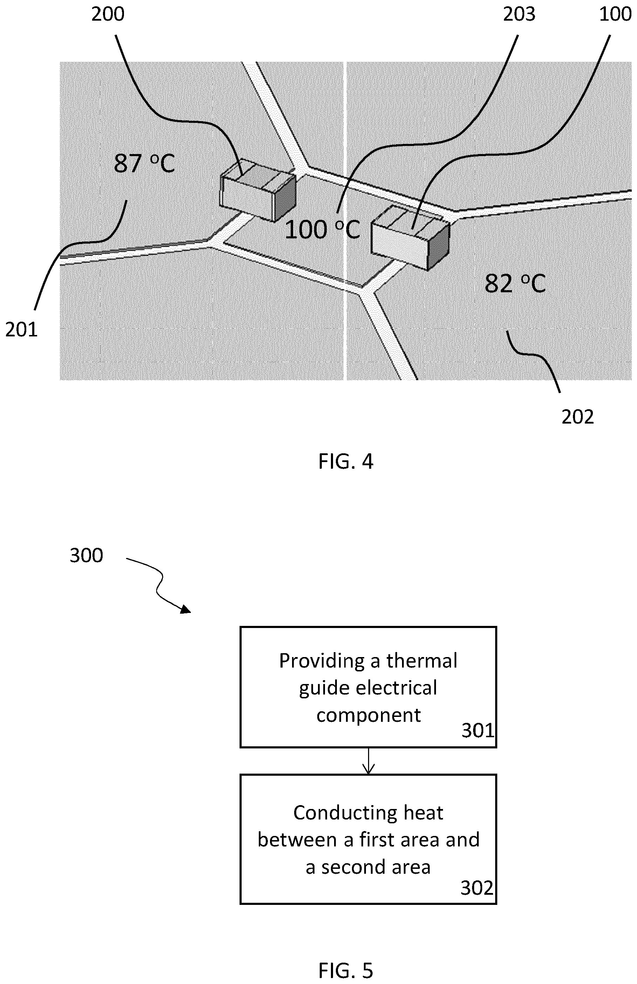

Fig. 4 shows simulation setup demonstrating the efficiency of the thermal guide electrical component disclosed herein compared to a Q-bridge thermal conductor of a similar size, and constructed with Aluminium Nitride (AIN). Fig. 4 shows a simulation setup where two different thermal guides are compared. A Q-guide manufactured with an AIN substrate (200) is compared with the thermal guide electrical component (100) as disclosed herein. A first area (203) where the temperature is set to 100 °C, is thermally connected on both sides by either the Q-guide (200) or the thermal guide electrical component (100) to two separate areas, where the Q-guide is connected to a left area (201) and the thermal guide electrical component is connected to the right area (202). Simulation results estimate the temperature of the left area (201) being 87 °C while the temperature of the right area (202) being 82 °C. This shows that the thermal guide electrical component (100) as disclosed herein is effective in conducting heat from a first area (203) to a second area, which is the right area (202) in this specific example. The 5-degrees difference between the left area (201) and the right area (202) may be explained by the higher thermal conductivity of the AIN substrate of the Q-guide (200), but the price and the manufacturing complexity of the Q-guide (200) may be way higher than the improved thermal dissipation efficiency it has over the thermal guide electrical component price (100).

The third portion can be arranged or deposited on the fourth silicon substrate. The at least two first portions can be arranged or deposited on the third portion. The first portion can be arranged or deposited on the third portion. The first portion can be arranged or deposited on the second portion, wherein the second portion can be deposited on the third portion. The at least two first portions can be arranged or deposited on the third portion such that the third portion may form an electrical barrier between the at least two first portions and the fourth silicon substrate portion.

In another aspect, a method of conducting heat between a first and a second area comprising the steps of providing a thermal guide electrical component configured for conducting heat between a first and a second area comprising at least two first portions, wherein the first portions are electrically conductive connector portions connectable to the first and the second area; a third portion, wherein the third portion is at least one layer of an electrically isolative material arranged on the at least two first portions; and a fourth silicon substrate portion, wherein the fourth silicon substrate portion is arranged on the third portion such that the third portion forms an electrical barrier between the at least two first portions and the fourth silicon substrate portion; wherein the thermal guide electrical component is configured to transfer a principal heat portion from the first area through the third portion to the fourth silicon substrate portion, further through the fourth silicon substrate portion to the second area via the third portion; and conducting heat between the first and the second area.

In a preferred embodiment, the method further comprises a step of providing a second portion, wherein the second portion is a thermally conductive and substantially non electrically conductive portion connecting the at least two first portions to each other. The thermal guide electrical component as described in the method may be the thermal guide electrical component as disclosed herein.

## Claims

1. A thermal guide electrical component (100) configured for conducting heat between a first area (203) and a second area (202) comprising:
a fourth silicon substrate portion (104);
a third portion (103), wherein the third portion (103) is at least one layer of an electrically isolative portion deposited on the fourth silicon substrate portion (104); and
at least two first portions (101; 102), wherein the at least two first portions (101; 102) are electrically conductive connector portions connectable to the first area (203) and the second area (202) respectively and deposited on the third portion (103);
wherein the thermal guide electrical component (100) is configured to transfer a principal heat portion from the first area (203) through the third portion (103) to the fourth silicon substrate portion (104), further through the fourth silicon substrate portion (104) to the second area (202) via the third portion (103);
**characterized in that** the third portion (103) forms an electrical barrier, wherein the electrical barrier isolates the at least two first portions (101; 102) and the fourth silicon substrate portion (104) from each other.

2. The thermal guide electrical component (100) according to claim 1, wherein the thermal guide electrical component (100) further comprises a second portion (105), wherein the second portion (105) is a thermally conductive and non-electrically conductive, and wherein the second portion (105) is deposited between the at least two first portions (101;102) and the third portion (103).

3. The thermal guide electrical component (100) according to claim 2, wherein at least one trench (109) is etched within the second portion (105), and wherein the at least two first portions (101;102) are deposited on the second portion (105) and wherein the at least one trench (109) is filled with the at least two first portions (101;102).

4. The thermal guide electrical component (100) according to claim 3, wherein the at least one trench (109) has a trench depth, and wherein the trench depth is lower than a second portion thickness, such that the at least one trench penetrates the second portion (105) down to 10 %, preferably 20 %, more preferably 50 %, even more preferably 75 %, most preferably 90 % of the second portion thickness.

5. The thermal guide electrical component (100) according to any one of claims 2-4, wherein the second portion (105) is configured to assist in transferring the principal heat from the at least two first portions (101; 102) to the third portion (103), thereby assisting the fourth silicon substrate portion (104) in transferring the principal heat from the first area (203) to the second area (202).

6. The thermal guide electrical component (100) according to any one of the preceding claims, wherein the at least two first portions (101; 102) are made of an electrically conductive material, preferably a solderable material, and preferably a metal, such as Copper (Cu).

7. The thermal guide electrical component (100) according to any one of the preceding claims, wherein the second portion (105) is thicker where in contact with the at least two first portions (101;102).

8. The thermal guide electrical component (100) according to any one of the preceding claims, wherein the thermally conductive and non-electrically conductive second portion (105) is made with a material comprising aluminium, such as aluminium oxide (Al₂O₃) and/or aluminium nitride (AIN).

9. The thermal guide electrical component (100) according to any one of the preceding claims, wherein the electrically isolative third portion (103) is made with a material comprising silicon, such as silicon nitride (Si₃N₄) and/or silicon dioxide (SiO₂).

10. The thermal guide electrical component (100) according to any one of the preceding claims, wherein the thermal guide electrical component (100) further comprises a fifth portion (106) arranged or deposited between the third portion (103) and the fourth substrate portion (104), wherein the fifth portion (106) is a diffusion barrier layer.

11. The thermal guide electrical component (100) according to any one of the preceding claims, wherein the fourth silicon substrate portion (104) has a fourth silicon substrate portion thickness between 100 and 525 µm.

12. The thermal guide electrical component (100) according to any one of the preceding claims, wherein the second portion thickness is between 20 and 400 nm.

13. The thermal guide electrical component (100) according to any one of the preceding claims, wherein the third portion (103) has a third portion thickness between 0.1 and 5 µm.

14. A method (300) of conducting heat between a first area (203) and a second area (202) comprising the steps of:
providing (301) a thermal guide electrical component (100) according to claim 1;
connecting one (102) of the at least two first portions (101; 102) to the first area (203) and the second one (101) of the at least two first portions (101; 102) to the second area (202);
conducting heat between the first area (203) and the second area (202).

15. The method (300) according to claim 14, wherein the thermal guide electrical component (100) is the thermal guide electrical component (100) according to any one of claims 2-13.

## Patentansprüche

1. Elektrische Wärmeleitkomponente (100), die zum Leiten von Wärme zwischen einem ersten Bereich (203) und einem zweiten Bereich (202) konfiguriert ist, umfassend:
einen vierten Siliciumsubstratabschnitt (104);
einen dritten Abschnitt (103), wobei der dritte Abschnitt (103) mindestens eine Schicht eines elektrisch isolierenden Abschnitts ist, der auf dem vierten Siliciumsubstratabschnitt (104) abgeschieden ist; und
mindestens zwei erste Abschnitte (101; 102), wobei die mindestens zwei ersten Abschnitte (101; 102) elektrisch leitfähige Verbinderabschnitte sind, die mit dem ersten Bereich (203) bzw. dem zweiten Bereich (202) verbindbar und auf dem dritten Abschnitt (103) abgeschieden sind;
wobei die elektrische Wärmeleitkomponente (100) konfiguriert ist, um einen Hauptwärmeanteil von dem ersten Bereich (203) durch den dritten Abschnitt (103) auf den vierten Siliciumsubstratabschnitt (104), weiter durch den vierten Siliciumsubstratabschnitt (104) über den dritten Abschnitt (103) auf den zweiten Bereich (202) zu übertragen;
**dadurch gekennzeichnet, dass** der dritte Abschnitt (103) eine elektrische Barriere bildet, wobei die elektrische Barriere die mindestens zwei ersten Abschnitte (101; 102) und den vierten Siliciumsubstratabschnitt (104) voneinander isoliert.

2. Elektrische Wärmeleitkomponente (100) nach Anspruch 1, wobei die elektrische Wärmeleitkomponente (100) ferner einen zweiten Abschnitt (105) umfasst, wobei der zweite Abschnitt (105) thermisch leitfähig und nicht elektrisch leitfähig ist, und wobei der zweite Abschnitt (105) zwischen den mindestens zwei ersten Abschnitten (101; 102) und dem dritten Abschnitt (103) abgeschieden ist.

3. Elektrische Wärmeleitkomponente (100) nach Anspruch 2, wobei mindestens ein Graben (109) in den zweiten Abschnitt (105) geätzt ist, und wobei die mindestens zwei ersten Abschnitte (101; 102) auf dem zweiten Abschnitt (105) abgeschieden sind, und wobei der mindestens eine Graben (109) mit den mindestens zwei ersten Abschnitten (101; 102) gefüllt ist.

4. Elektrische Wärmeleitkomponente (100) nach Anspruch 3, wobei der mindestens eine Graben (109) eine Grabentiefe aufweist, und wobei die Grabentiefe geringer als eine Dicke des zweiten Abschnitts ist, sodass der mindestens eine Graben den zweiten Abschnitt (105) bis hinab zu 10 %, vorzugsweise 20 %, bevorzugter 50 %, noch bevorzugter 75 %, am meisten bevorzugt 90 % der Dicke des zweiten Abschnitts durchdringt.

5. Elektrische Wärmeleitkomponente (100) nach einem der Ansprüche 2 bis 4, wobei der zweite Abschnitt (105) konfiguriert ist, um beim Übertragen der Hauptwärme von den mindestens zwei ersten Abschnitten (101; 102) auf den dritten Abschnitt (103) zu unterstützen, wodurch der vierte Siliciumsubstratabschnitt (104) beim Übertragen der Hauptwärme von dem ersten Bereich (203) auf den zweiten Bereich (202) unterstützt wird.

6. Elektrische Wärmeleitkomponente (100) nach einem der vorhergehenden Ansprüche, wobei die mindestens zwei ersten Abschnitte (101; 102) aus einem elektrisch leitfähigen Material, vorzugsweise einem lötbaren Material, und vorzugsweise einem Metall, wie etwa Kupfer (Cu), hergestellt sind.

7. Elektrische Wärmeleitkomponente (100) nach einem der vorhergehenden Ansprüche, wobei der zweite Abschnitt (105) dort dicker ist, wo er in Kontakt mit den mindestens zwei ersten Abschnitten (101; 102) ist.

8. Elektrische Wärmeleitkomponente (100) nach einem der vorhergehenden Ansprüche, wobei der thermisch leitfähige und nicht elektrisch leitfähige zweite Abschnitt (105) mit einem Material hergestellt ist, das Aluminium umfasst, wie etwa Aluminiumoxid (Al₂O₃) und/oder Aluminiumnitrid (AlN).

9. Elektrische Wärmeleitkomponente (100) nach einem der vorhergehenden Ansprüche, wobei der elektrisch isolierende dritte Abschnitt (103) mit einem Material hergestellt ist, das Silicium umfasst, wie etwa Siliciumnitrid (Si₃N₄) und/oder Siliciumdioxid (SiO₂).

10. Elektrische Wärmeleitkomponente (100) nach einem der vorhergehenden Ansprüche, wobei die elektrische Wärmeleitkomponente (100) ferner einen fünften Abschnitt (106) umfasst, der zwischen dem dritten Abschnitt (103) und dem vierten Substratabschnitt (104) angeordnet oder abgeschieden ist, wobei der fünfte Abschnitt (106) eine Diffusionsbarrierenschicht ist.

11. Elektrische Wärmeleitkomponente (100) nach einem der vorhergehenden Ansprüche, wobei der vierte Siliciumsubstratabschnitt (104) eine Dicke des vierten Siliciumsubstratabschnitts zwischen 100 und 525 µm aufweist.

12. Elektrische Wärmeleitkomponente (100) nach einem der vorhergehenden Ansprüche, wobei die Dicke des zweiten Abschnitts zwischen 20 und 400 nm liegt.

13. Elektrische Wärmeleitkomponente (100) nach einem der vorhergehenden Ansprüche, wobei der dritte Abschnitt (103) eine Dicke des dritten Abschnitts zwischen 0,1 und 5 µm aufweist.

14. Verfahren (300) zum Leiten von Wärme zwischen einem ersten Bereich (203) und einem zweiten Bereich (202), umfassend die Schritte:
Bereitstellen (301) einer elektrischen Wärmeleitkomponente (100) nach Anspruch 1;
Verbinden eines (102) der mindestens zwei ersten Abschnitte (101; 102) mit dem ersten Bereich (203) und des zweiten (101) der mindestens zwei ersten Abschnitte (101; 102) mit dem zweiten Bereich (202);
Leiten von Wärme zwischen dem ersten Bereich (203) und dem zweiten Bereich (202).

15. Verfahren (300) nach Anspruch 14, wobei die elektrische Wärmeleitkomponente (100) die elektrische Wärmeleitkomponente (100) nach einem der Ansprüche 2 bis 13 ist.

## Revendications

1. Composant électrique de guidage thermique (100) configuré pour conduire la chaleur entre une première zone (203) et une seconde zone (202) comprenant :
une quatrième partie de substrat de silicium (104) ;
une troisième partie (103), dans lequel la troisième partie (103) est au moins une couche d'une partie électriquement isolante déposée sur la quatrième partie de substrat de silicium (104) ; et
au moins deux premières parties (101 ; 102), dans lequel les au moins deux premières parties (101 ; 102) sont des parties de connecteurs électriquement conductrices connectables respectivement à la première zone (203) et à la seconde zone (202) et déposées sur la troisième partie (103) ;
dans lequel le composant électrique de guidage thermique (100) est configuré pour transférer une partie principale de chaleur de la première zone (203) à travers la troisième partie (103) jusqu'à la quatrième partie de substrat de silicium (104), puis à travers la quatrième partie de substrat de silicium (104) jusqu'à la seconde zone (202) via la troisième partie (103) ;
**caractérisé en ce que** la troisième partie (103) forme une barrière électrique, dans lequel la barrière électrique isole les au moins deux premières parties (101 ; 102) et la quatrième partie de substrat de silicium (104) les unes des autres.

2. Composant électrique de guidage thermique (100) selon la revendication 1, dans lequel le composant électrique de guidage thermique (100) comprend en outre une deuxième partie (105), dans lequel la deuxième partie (105) est thermiquement conductrice et non électriquement conductrice, et dans lequel la deuxième partie (105) est déposée entre les au moins deux premières parties (101 ; 102) et la troisième partie (103).

3. Composant électrique de guidage thermique (100) selon la revendication 2, dans lequel au moins une tranchée (109) est gravée dans la deuxième partie (105), et dans lequel les au moins deux premières parties (101 ; 102) sont déposées sur la deuxième partie (105) et dans lequel l'au moins une tranchée (109) est remplie par les au moins deux premières parties (101 ; 102).

4. Composant électrique de guidage thermique (100) selon la revendication 3, dans lequel l'au moins une tranchée (109) a une profondeur de tranchée, et dans lequel la profondeur de tranchée est inférieure à l'épaisseur d'une deuxième partie, de sorte que l'au moins une tranchée pénètre dans la deuxième partie (105) jusqu'à 10 %, de préférence 20 %, de manière davantage préférée 50 %, encore plus particulièrement 75 %, de manière préférée entre toutes 90 % de l'épaisseur de deuxième partie.

5. Composant électrique de guidage thermique (100) selon l'une quelconque des revendications 2 à 4, dans lequel la deuxième partie (105) est configurée pour aider à transférer la chaleur principale des au moins deux premières parties (101 ; 102) à la troisième partie (103), aidant ainsi la quatrième partie de substrat de silicium (104) à transférer la chaleur principale de la première zone (203) à la seconde zone (202).

6. Composant électrique de guidage thermique (100) selon l'une quelconque des revendications précédentes, dans lequel les au moins deux premières parties (101 ; 102) sont constituées d'un matériau électriquement conducteur, de préférence un matériau soudable, et de préférence un métal, tel que le cuivre (Cu).

7. Composant électrique de guidage thermique (100) selon l'une quelconque des revendications précédentes, dans lequel la deuxième partie (105) est plus épaisse lorsqu'elle est en contact avec les au moins deux premières parties (101 ; 102).

8. Composant électrique de guidage thermique (100) selon l'une quelconque des revendications précédentes, dans lequel la deuxième partie thermiquement conductrice et non électriquement conductrice (105) est constituée d'un matériau comprenant de l'aluminium, tel que l'oxyde d'aluminium (Al₂O₃) et/ou le nitrure d'aluminium (AlN).

9. Composant électrique de guidage thermique (100) selon l'une quelconque des revendications précédentes, dans lequel la troisième partie électriquement isolante (103) est constituée d'un matériau comprenant du silicium, tel que le nitrure de silicium (Si₃N₄) et/ou le dioxyde de silicium (SiO₂).

10. Composant électrique de guidage thermique (100) selon l'une quelconque des revendications précédentes, dans lequel le composant électrique de guidage thermique (100) comprend en outre une cinquième partie (106) disposée ou déposée entre la troisième partie (103) et la quatrième partie de substrat (104), dans lequel la cinquième partie (106) est une couche barrière de diffusion.

11. Composant électrique de guidage thermique (100) selon l'une quelconque des revendications précédentes, dans lequel la quatrième partie de substrat de silicium (104) a une épaisseur de quatrième partie de substrat de silicium comprise entre 100 et 525 µm.

12. Composant électrique de guidage thermique (100) selon l'une quelconque des revendications précédentes, dans lequel l'épaisseur de deuxième partie est comprise entre 20 et 400 nm.

13. Composant électrique de guidage thermique (100) selon l'une quelconque des revendications précédentes, dans lequel la troisième partie (103) a une épaisseur de troisième partie comprise entre 0,1 et 5 µm.

14. Procédé (300) de conduction de chaleur entre une première zone (203) et une seconde zone (202) comprenant les étapes suivantes :
la fourniture (301) d'un composant électrique de guidage thermique (100) selon la revendication 1 ;
le fait de relier une (102) des au moins deux premières parties (101 ; 102) à la première zone (203) et la seconde (101) des au moins deux premières parties (101 ; 102) à la seconde zone (202) ;
la conduction de la chaleur entre la première zone (203) et la seconde zone (202).

15. Procédé (300) selon la revendication 14, dans lequel le composant électrique de guidage thermique (100) est le composant électrique de guidage thermique (100) selon l'une quelconque des revendications 2 à 13.
